# EUROPÄISCHE PATENTSCHRIFT

(11) **EP 2 088 843 B1**
(45) Veröffentlichungstag und Bekanntmachung des Hinweises auf die Patenterteilung: **18.07.2018**
(21) Anmeldenummer: 08170471.0
(22) Anmeldetag: 02.12.2008
(51) Int. Cl.: H05K 7/20

(54) **Flüssigkeitsgekühlte Filter oder Filterkomponenten**
Fluid-cooled filter or filter components
Filtre refroidi par liquide ou composants de filtre

(30) Priorität: 07.02.2008 AT 1932008
(43) Veröffentlichungstag der Anmeldung: 12.08.2009
(73) Patentinhaber: Siemens Aktiengesellschaft, 80333 München (DE)
(72) Erfinder: Damec, Vladislav, 691 43 Hlohovec (CZ); Reischer, Wilhelm, 1210 Wien (AT)
(74) Vertreter: Maier, Daniel Oliver

(56) Entgegenhaltungen:
- WO-A-2008/055515
- DE-A1- 3 026 881
- US-A- 3 858 090

## Beschreibung

### Technisches Gebiet

Die Erfindung betrifft eine Umrichterschaltung, die ein Wickelgut und/oder zumindest eine Filterschaltung umfasst, gemäß dem Oberbegriff des Anspruchs 1.

### Stand der Technik

Umrichterschaltungen gewinnen zunehmend an Bedeutung, wobei man bei der Weiterentwicklung dieser Schaltungen bestrebt ist, sie möglichst kompakt und somit Platz sparend auszuführen. Dabei ist darauf zu achten, die in den elektronischen Bauteilen auftretende Verlustleistung, die sich in einer Erwärmung der Bauteile äußert, wärmetechnisch abzuführen. Hierzu wird in der Regel das Luftinventar des Schrankes, in dem die Umrichterschaltung untergebracht ist, über einen Luft-Flüssigkeit-Wärmetauscher entwärmt. Diese Wärmetauscher erfordern einen Lüfter, der wiederum entsprechenden Platzbedarf aufweist. Außerdem verursacht eine solche Kühlung zusätzliche Kosten, Lärm, sowie zusätzlichen Wartungsaufwand, und erfordert eine eigene Stromversorgung. Bei zunehmendem Kühlungsaufwand werden diese Nachteile immer schwer wiegender, sodass man von einer Verringerung der Aufbaugröße von Umrichterschaltungen Abstand nimmt.

Aus dem Stand der Technik sind auch flüssigkeitsgekühlte Umrichterschaltungen bekannt. Beispielsweise offenbart die DE 30 26 881 A1 eine Wechselrichterschaltung, welche einen Gleichrichterteil, einen Filterteil und einen Wechselrichter umfasst. Diese Komponenten des Leistungsteils sind in einem gemeinsamen Gehäuse zur Kühlung angeordnet. Ebenso verhält es sich bei der US-A-3 858 090. Auch hier sind alle Leistungskomponenten in einem flüssigkeitsgekühlten Gehäuse angeordnet.

### Darstellung der Erfindung

Es ist daher das Ziel der Erfindung Maßnahmen vorzuschlagen, die bei Umrichterschaltungen eine kompaktere und Platz sparende Bauweise ermöglichen.

Diese Ziele werden durch die Merkmale von Anspruch 1 verwirklicht.

Anspruch 1 bezieht sich dabei auf eine Umrichterschaltung, die ein Wickelgut und/oder zumindest eine Filterschaltung umfasst. Erfindungsgemäß wird vorgeschlagen, dass lediglich Bauelemente der zumindest einen Filterschaltung und/oder das Wickelgut mit einem Gehäuse umgeben sind, das mit einer elektrisch isolierenden Kühlflüssigkeit gefüllt ist, und ein Wärmetauscher zur Abfuhr der Wärme der Kühlflüssigkeit vorgesehen ist. Somit ist erfindungsgemäß eine Flüssigkeitskühlung für die Bauelemente der Filterschaltung bzw. das Wickelgut vorgesehen. Das erfindungsgemäße Gehäuse verfügt lediglich über die entsprechenden elektrischen Anschlüsse, sowie über die Zu- und Ableitungen für die Kühlflüssigkeit. Ansonsten ist das Gehäuse aber flüssigkeitsdicht ausgeführt. Der Wärmetauscher kann dabei innerhalb des Gehäuses angeordnet sein, oder auch außerhalb.

Mit dieser Vorgangsweise ist eine Reihe von Vorteilen verbunden. So stellt etwa eine Flüssigkeitskühlung eine effektive Kühlungsmethode dar, die Verlustleistungen rascher abzuführen vermag, als luftunterstützte Kühlung. Des Weiteren kann aufgrund der Konvektion der Kühlflüssigkeit im Gehäuse auf Umwälzeinrichtungen wie Pumpen und dergleichen verzichtet werden, insbesondere kann auch der im Stand der Technik verwendete Lüfter entfallen, sodass die damit verbundenen Nachteile wie Kosten, Platzerfordernis, Strombedarf, Lärm, sowie Wartungsaufwand entfallen.

Schließlich zeigt sich, dass die erfindungsgemäße Lösung zusätzliche Vorteile zeigt, die die praktische Anwendbarkeit der Erfindung attraktiv erscheinen lassen. So bestehen etwa für Umrichterschaltungen strenge gesetzliche Anforderungen hinsichtlich des Schutzes vor dem Eindringen von Fremdkörpern, oder auch von Wasser. Mit der erfindungsgemäßen Lösung erübrigen sich diese Anforderungen, da durch die Umhüllung der elektronischen Bauelemente des Filter bzw. des Wickelgutes mit einer elektrisch isolierenden Kühlflüssigkeit automatisch ein Schutz vor Fremdkörpern, sowie vor elektrisch leitendem Wasser gegeben ist.

Gemäß einer vorteilhaften Weiterbildung der Erfindung handelt es sich bei der Kühlflüssigkeit um elektrisch isolierendes Öl. Es ist aber auch denkbar, dass andere Kühlflüssigkeiten verwendet werden können, sofern sie über die erforderlichen Isolationseigenschaften verfügen. Öl wird in der Elektrotechnik in erster Linie zur elektrischen Isolierung von Bauteilen verwendet. Im Zusammenhang mit der vorliegenden Erfindung wird aber seine Kühlwirkung ausgenutzt, wenngleich insbesondere im Mittelspannungsbereich auch seine isolierenden Eigenschaften durchaus wesentlich werden können.

Gemäß einer bevorzugten Ausführungsform der Erfindung sind die mit dem Gehäuse umgebenen Bauelemente der zumindest einen Filterschaltung und das Wickelgut innerhalb desselben Gehäuses angeordnet. Dadurch wird eine Integration des Wickelgutes, etwa einer Drossel oder eines Transformators, und Widerständen zu einer Filterkomponente möglich. Das ermöglicht wiederum geringeren Platzbedarf, sowie geringere Kosten.

Zusätzlich zum Wickelgut können auch allfällige Verlustleistungserzeuger wie etwa Bedämpfungswiderstände innerhalb des Gehäuses angeordnet werden. Diese Widerstände werden sinnvoller Weise als Rohrmantelwiderstände ausgeführt, wie sie beispielsweise für Waschmaschinenheizungen verwendet werden. Widerstände, etwa solche mit isolierter Bodenplatte, können auch in geeigneter Weise am Gehäuse befestigt werden.

Vorteilhafter Weise wird das Gehäuse aus austenitischem (unmagnetischem) Edelstahl hergestellt, um negative Einflüsse von magnetischen Streufeldern zu verringern. Des Weiteren können auch offen gewickelte, zementierte oder glasierte Widerstände in ihren gängigen Bauformen, sowie Schicht- oder Massewiderstände direkt im erfindungsgemäßen Gehäuse gekühlt werden.

Die Erfindung kann dabei auch für bereits verwirklichte, luftgekühlte Drosseln eingesetzt werden. Hierzu ist lediglich ein Einbau der luftgekühlten Drosselausführung bzw. einzelner Komponenten in ein erfindungsgemäßes Gehäuse erforderlich. Dadurch wird zunehmende Typenvielfalt und zusätzlicher Entwicklungsaufwand für Umrichterschaltungen bzw. deren Komponenten vermieden.

Mithilfe der erfindungsgemäßen Maßnahmen wird somit bei Umrichterschaltungen eine kompaktere und Platz sparende Bauweise ermöglicht.

## Patentansprüche

1. Umrichterschaltung, die ein Wickelgut und/oder zumindest eine Filterschaltung umfasst, **dadurch gekennzeichnet, dass** lediglich Bauelemente der zumindest einen Filterschaltung und/oder das Wickelgut mit einem Gehäuse umgeben sind, das mit einer elektrisch isolierenden Kühlflüssigkeit gefüllt ist, und ein Wärmetauscher zur Abfuhr der Wärme der Kühlflüssigkeit vorgesehen ist.

2. Umrichterschaltung nach Anspruch 1, **dadurch gekennzeichnet, dass** es sich bei der Kühlflüssigkeit um elektrisch isolierendes Öl handelt.

3. Umrichterschaltung nach Anspruch 1, **dadurch gekennzeichnet, dass** die mit dem Gehäuse umgebenen Bauelemente der zumindest einen Filterschaltung und das Wickelgut innerhalb desselben Gehäuses angeordnet sind.

## Claims

1. Converter circuit comprising a winding material and/or at least one filter circuit, **characterised in that** only components of the at least one filter circuit and/or the winding material are surrounded by a housing which is filled with an electrically insulating cooling fluid, and a heat exchanger is provided to discharge the heat from the cooling fluid.

2. Converter circuit according to claim 1, **characterised in that** the cooling fluid is electrically insulating oil.

3. Converter circuit according to claim 1, **characterised in that** the components of the at least one filter circuit, surrounded by the housing, and the winding material are arranged within the same housing.

## Revendications

1. Circuit de conversion de fréquence, qui englobe un matériau à bobiner et/ou au moins un circuit de filtrage, **caractérisé en ce que** seuls les composants de l'au moins un circuit de filtrage et/ou le matériau à bobiner est/sont entouré (s) d'un carter, rempli d'un liquide de refroidissement électriquement isolant, et un échangeur de chaleur est prévu pour évacuer la chaleur du liquide de refroidissement.

2. Circuit de conversion de fréquence selon la revendication 1, **caractérisé en ce que** le liquide de refroidissement est une huile électriquement isolante.

3. Circuit de conversion de fréquence selon la revendication 1, **caractérisé en ce que** les composants entourés par le carter de l'au moins un circuit de filtrage et le matériau à bobiner sont disposés dans le même carter.
